Europäisches Patentamt

European Patent Office

Office européen des brevets

(11) Publication number: **0 019 987**
A1

## EUROPEAN PATENT APPLICATION

(21) Application number: 80300162.7

(22) Date of filing: 17.01.80

(51) Int. Cl.³: **G 11 C 7/00**, G 11 C 17/00, H 03 K 3/356, H 03 K 5/02

(30) Priority: 01.06.79 US 44447

(43) Date of publication of application: 10.12.80
Bulletin 80/25

(84) Designated Contracting States: DE FR GB

(71) Applicant: MOTOROLA, INC., 4350 East Camelback Road Suite 200F, Phoenix, Arizona 85018 (US)

(72) Inventor: Peterson, Benjamin Clifford, 5438 South Heather Drive, Tempe, Arizona 85283 (US)

(74) Representative: Newens, Leonard Eric et al, F.J. CLEVELAND CO. 40/43 Chancery Lane, London WC2A 1JQ (GB)

(54) **High speed IGFET sense amplifier/latch.**

(57) A latching type sense amplifier for use in conjunction with a read-only memory 2 employs a pair of depletion mode devices (44 and 46) which serve as both load devices for the latch and as means for coupling a bit line node 30 and a reference voltage to the sense amplifier. Prior to sensing, the bit line node 30 and the switching nodes (48 and 50) are precharged and balanced. The precharge on the switching nodes is one enhancement threshold below the supply voltage (VDD). Selection of a programmed memory cell causes the bit line node 30 to discharge. The sense amplifier is activated at a time sufficient to allow the bit line voltage to fall a few millivolts below the reference voltage.

# HIGH SPEED IGFET SENSE AMPLIFIER/LATCH

## BACKGROUND OF THE INVENTION

1.    Field of the Invention

This invention relates generally to semiconductor memory circuits which require sensing against a fixed reference voltage and, more particularly, to an improved insulated-gate field-effect transistor (IGFET) sense amplifier suitable for use in conjunction with a read-only memory (ROM).

2.    Description of the Prior Art

U.S. Patent No. 4,123,799 entitled "A High Speed IGFET Sense Amplifier/Latch" describes a latching type sense amplifier to be used in conjunction with a static IGFET random-access- memory (RAM).  A pair of depletion mode devices serve as load devices for the latch and as means for coupling a pair of bit lines to the sense amplifier. Prior to sensing, the bit lines and the switching nodes of the latch are precharged and balanced.

The selection of a memory cell induces a small differential voltage across the bit lines, causing one of the load devices to be more conductive than the other. When the latch is enabled, regenerative amplification causes the latch to seek one of two stable states as determined by the relative conductivities of the two load devices thereby latching the state of the data stored in the selected memory cell.

The selection of a ROM memory cell does not result in the production of a differential voltage.  It merely provides a discharge path for a data voltage node.  It was first believed that the sense amplifier of the above cited patent could still be utilized by coupling one of the input load devices to the data voltage node and by coupling the other input load device to a reference voltage.  However, this resulted in an inability to control the voltage at the switching nodes of the latch.

## SUMMARY OF THE INVENTION

It is an object of the present invention to provide a sense amplifier for an IGFET read-only-memory which is highly sensitive to the difference between the bit line voltage and a reference voltage.

It is a further object of the invention to provide a sense amplifier for an IGFET read-only-memory which can amplify and latch the state of a selected memory cell very shortly after selection of the cell.

It is yet another object of the invention to provide a sense amplifier for an IGFET read-only memory which uses depletion mode field-effect-transistors to isolate the switching nodes of the latch from the bit line and the reference voltage.

Finally, it is an object of the invention to provide a monolithically integrable sense amplifier which permits data stored in a read-only-memory to be sensed at a high rate of speed over a wide range of ambient temperature conditions.

According to a broad aspect of the invention there is provided a sense amplifier coupled to a source of supply voltage for receiving a reference voltage and a voltage data signal from a memory cell, comprising: a cross coupled latching circuit containing first and second switching nodes; first means for precharging and clamping said switching nodes at a first voltage having a maximum which is a predetermined fraction of said supply voltage; and first and second switching devices coupled to said latching circuit for coupling said data signal and said reference voltage to said latching circuit and for providing differential load impedances for forcing said latching circuit into one of two states.

The above and other objects, features and advantages of the present invention will be better understood from the following detailed description taken in conjunction with the accompanying drawings, in which:

## BRIEF DESCRIPTION OF THE DRAWINGS

Figure 1 is a schematic diagram of a sense amplifier according to the present invention; and

Figure 2 is a timing diagram which demonstrates the operation of the sense amplifier shown in Figure 1.

## DESCRIPTION OF THE PREFERRED EMBODIMENT

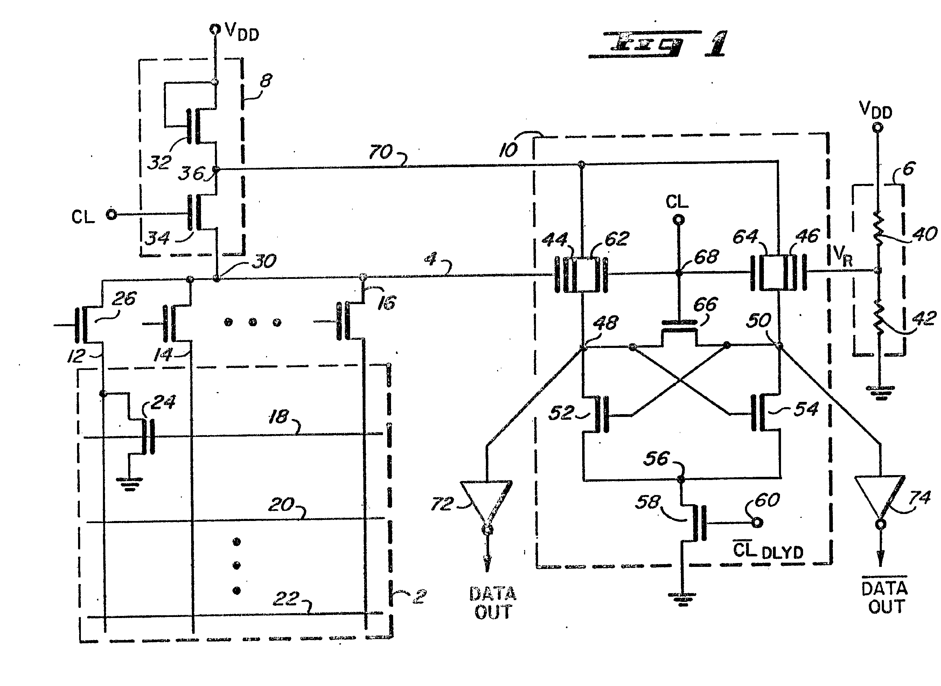

Referring to FIGURE 1, there is shown a memory circuit which includes a read only memory 2, a bit line represented by conductor 4, a reference voltage generator 6, pre-charge circuitry 8 and a sense amplifier 10 having a first input coupled to the data bit line 4 and having a second input coupled to the reference voltage ($V_R$). The memory 2 may be comprised of a plurality of columns (e.g. 12, 14, 16) and a plurality of rows (e.g. 18, 20, 22). The intersections of each of the columns and rows may or may not be occupied by a transistor such as is shown at 24 depending on whether particular location in memory 2 is to represent a binary ONE or ZERO; i.e. the presence of a transistor represents a ONE at that location in memory. A particular location is accessed by selectively energizing a particular row and column as is well known in the art. In FIGURE 1, a particular column is energized by applying a column select signal to the gate electrode of a particular column select transistor, for example 26, the current conducting path of which is in series with column select line 12. The drain electrode of each of the column select transistors is coupled to bit line 4.

The pre-charge circuitry 8 is coupled between VDD and the bit line 4 at node 30, and comprises first and second series connected field effect transistors 32 and 34 respectively. The gate electrode of transistor 32 is coupled to its drain electrode, and the gate electrode of transistor 34 is coupled to a source of clock signals CL. The junction of the source of transistor 32 and the drain of transistor 34 is denoted by node 36.

The reference voltage $V_R$ is generated at the junction of two resistors 40 and 42, preferably polysilicon, coupled in series between VDD and ground. If resistors 40 and 42 are equal, a reference voltage of VDD/2 (approximately 2.5 volts) will be generated.

Bit line 4 is coupled to the gate electrode of depletion mode IGFET device 44, and the reference voltage $V_R$ is connected to the gate electrode of depletion mode IGFET device 46. Depletion mode devices 44 and 46 couple bit line 4 and $V_R$ to switching nodes 48 and 50 of sense amplifier 10. Node 48 is coupled to the drain of device 52 and also to the gate of device 54. Similarly, node 50 is coupled to the drain of device 54 and to the gate of device 52. The source of device 52 is common to the source of device 54 at node 56. Device 58, coupled between node 56 and ground, is used to enable sense amplifier 10, and is controlled by a delayed inverted clock voltage $\overline{CL}_{DLYD}$ applied to terminal 60. Also coupled to nodes 48 and 50 of sense amplifier 10 are devices 62, 64 and 66. The gate electrodes of devices 62, 64 and 66 are all connected to node 68, the voltage of which is controlled by the clock voltage CL (approximately 5 volts). The drain terminals of devices 44, 46, 62, and 64 are all connected to node 36 by means of conductor 70. Nodes 48 and 50 serve as the true and complement outputs of sense amplifier circuit 10, and supply the data sensed from the memory cell to circuitry external from the memory circuit.

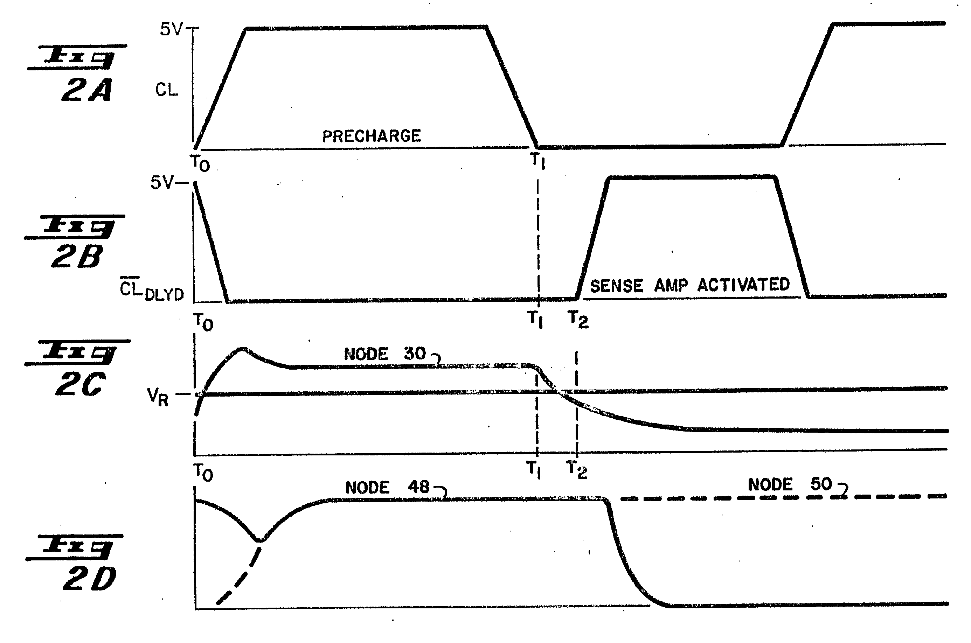

The operation of the preferred embodiment will now be described with the aid of the timing diagram shown in FIGURE 2. Prior to selection of a memory cell, the clock signal CL becomes high (5 volts) as is shown in FIGURE 2a thus activating precharge circuitry 8. That is, the clock signal CL turns on transistor 34 during this precharge phase. Because transistor 32 is coupled with its gate tied to its drain, the voltage at node 36 becomes fixed at VDD − V (THRESHOLD) or approximately 3.5 volts. The voltage at node 30 increases until it reaches some predetermined voltage which is a few millivolts greater than the reference voltage $V_R$. This situation is shown in that portion of FIGURE 2c corresponding to the precharge period.

When CL is at a high level (5 volts) devices 62, 64 and 66 are also rendered conductive. This has the effect of clamping the voltage at nodes 48 and 50 to the voltage at node 36 (3.5 volts). This is shown in FIGURE 2d where the solid curve represents the voltage at node 48 and the dotted curve represents the voltage at node 50. Thus, no matter how hard depletion sense devices 44 or 46 are driven during precharge, neither nodes 48 nor 50 can deviate from the voltage at node 36 assuming CL is a full level swing clock. This voltage clamping is critical to the operation since the sense amplifier inputs are not normally equalized, the first being coupled to $V_R$ and the second being susceptible to clock coupling transients. The arrangement shown in FIGURE 1 eliminates consideration of voltage differences or voltage equalization prior to the clock $\overline{CL}_{DLYD}$ going high.

Since the inverted complement of the clock signal ($\overline{CL}_{DLYD}$), supplied to the gate of device 58 via terminal 60, is low device 58 is non-conductive and no current is supplied to the source terminals of devices 52 and 54. During the precharging of sense amplifier circuit 10, depletion mode devices 44 and 46 are conducting.

However, devices 62 and 64 are much larger than load devices 44 and 46. Thus, from a transient point of view, precharge devices 62 and 64 dominate over devices 44 and 46 in setting the voltages on nodes 48 and 50 when enabled by clock voltage CL. Immediately prior to enabling the sense amplifier, the voltages at the source terminals of devices 44 and 46 are equal because device 66 is shorting node 48 to node 50. When CL goes low at time t1 (FIGURE 2a), transistors 62, 64 and 66 turn off disconnecting nodes 48 and 50. This permits node 48 to be controlled by the impedance of device 44 which is dependent upon the voltage at node 30. Similarly, node 50 is controlled by the impedance of transistor 46 which is dependent upon the reference voltage $V_R$.

When the clock CL goes low, memory 2 may be accessed. If the accessed location is programmed (i.e. contains a transistor such as at 24) the voltage at node 30 will begin to discharge. The $\overline{CL}_{DLYD}$ signal is delayed sufficiently to allow the voltage at node 30 to fall below $V_R$ by approximately 100 millivolts. This may take typically between 20 and 100 nanoseconds depending on circuit characteristics.

As is shown in FIGURES 2b and 2c, when a small differential voltage has been created between bit line 4 and $V_R$, the sense amplifier 10 is enabled by taking $\overline{CL}_{DLYD}$ high at time t2. At this time, devices 62, 64 and 66 are all turned off. Device 58, having a source coupled to ground and a drain coupled to node 56, turns on and allows current to flow through devices 52 and 54. Once enabled, devices 52 and 54 begin to pull current through load devices 44 and 46. Load device 44 has a higher impedance than load device 46 and a larger voltage will be developed across the drain and source terminals of device 44 than that developed across device 46 since the gate voltage of device 44 is slightly lower than that of device 46. The voltage at node 48 becomes lower than the voltage at node 50. As the voltage at node 48 moves toward ground, device 54 will conduct less and less current until the regenerative action of the circuit results in device 54 being made totally nonconducting while device 52 continues to conduct. The voltage on node 36 will be pulled to ground potential by the low impedance path through devices 52 and 58 while the voltage at node 50 will be pulled up to the voltage at node 36 (3.2 volts).

Because the logical state of the memory cell has now been latched in the sense amplifier, the column and row select voltages can now be removed without affecting the voltages on nodes 48 and 50. To prepare for the next sense cycle, the clock voltage CL shown in FIGURE 2a is again taken to a high level and the process repeated. Using a similar analysis, if the addressed location was not programmed, then the voltage at node 30 would remain higher than the reference voltage. In this case, when the sense amplifier is enabled, node 50 would go to ground and node 48 would be pulled up to 3.5 volts (the voltage at node 36). Inverters 72 and 74 are coupled to nodes 48 and 50 for supplying the DATA OUT and $\overline{\text{DATA OUT}}$ signals and for restoring the 3.5 volt signals to VDD.

For the sake of completeness, the following represents suitable dimensions for the MOS devices shown in FIGURE 1.

| DEVICE | WIDTH/LENGTH (Microns) |
|--------|------------------------|
| 24 | 9/6 |
| 32 | 255/6 |
| 34 | 180/6 |
| 44,46 | 10/30 |
| 62,64 | 60/6 |
| 66 | 72/6 |
| 52,54 | 36/6 |
| 58 | 100/6 |

The sense amplifier circuitry described above is capable of satisfactory operation in an environment which varies from -40°C to +140°C junction temperature with a supply voltage (VDD) variation of 4.5 to 5.5 volts.

The foregoing description of a preferred embodiment of the invention is given by way of example only. Changes in form and details may be made by one skilled in the art without departing from the spirit and scope of the invention as defined by the appended claims.

0019987

Claims

1. A sense amplifier coupled to a source of supply voltage for receiving a reference voltage and a voltage data signal from a memory cell, comprising:

a cross coupled latching circuit containing first and second switching nodes 48 and 50;

first means for precharging and clamping said switching nodes at a first voltage having a maximum which is a predetermined fraction of said supply voltage; and

first and second switching devices 44 and 46 coupled to said latching circuit for coupling said data signal and said reference voltage to said latching circuit and for providing differential load impedances for forcing said latching circuit into one of two states.

2. A sense amplifier according to claim 1 wherein said first means comprises:

a first IGFET device 32 having drain and gate electrodes coupled to said supply voltage and having a source electrode at which there is produced said first voltage;

a second IGFET device 62 having a gate coupled to a clock signal and having a source-drain path coupled between said first switching node and said first voltage for coupling said first switching node to said first voltage at the occurrence of said clock signal; and

a third IGFET device 64 having a gate coupled to said clock signal and having a source-drain path coupled between said second switching node and said first voltage for coupling said second switching node to said first voltage at the occurrence of said clock signal.

3. A sense amplifier according to claim 2 further including a fourth IGFET device 66 having a gate coupled to said clock signal and having a source-drain path coupled

- 2 -

0019987

between said first and second switching nodes for equalizing the potentials on said first and second switching nodes.

4. A sense amplifier according to claim 2 wherein said first and second switching devices 44 and 46 comprise first and second depletion mode IGFET devices, said first depletion mode IGFET 44 having a gate electrode coupled to said data voltage and having a source-drain path coupled between said first voltage and said first switching node 48, and said second depletion mode IGFET 46 having a gate electrode coupled to said reference voltage and having a source-drain path coupled between said first voltage and said second switching node 50.

5. A sense amplifier according to claim 4 wherein said voltage data signal is produced at a node 30 coupled to the gate electrode of said first depletion mode IGFET device and further comprising means 8 for precharging said node to a voltage greater than said reference voltage.

6. A sense amplifier according to claim 5 further including voltage dividing means 6 coupled between said supply voltage and ground for producing said reference voltage.

7. A sense amplifier according to claim 5 wherein said means for precharging said node comprises a fifth IGFET device 34 having a source-drain path coupled between said node and said first IGFET device and having a gate electrode coupled to said clock signal for precharing said node when said clock signal goes high.

8. A sense amplifier according to claim 6 wherein said voltage dividing means comprises first and second

- 3 -

0019987

resistors 40 and 42 having a junction coupled to the gate of said second depletion mode IGFET device 46.

9. A sense amplifier according to claim 7 wherein said cross-coupled circuit is energized a predetermined length of time after said clock signal goes low.

FIG 1

Fig 2A

Fig 2B

Fig 2C

Fig 2D

European Patent
Office

EUROPEAN SEARCH REPORT

0019987
Application number

EP 80 30 0162

## DOCUMENTS CONSIDERED TO BE RELEVANT

| Category | Citation of document with indication, where appropriate, of relevant passages | Relevant to claim |
|---|---|---|
| | ELECTRONICS, vol. 51, no. 7, 30th March 1978<br>New York US<br>WILSON: "Cell Layout Boosts Speed of Low-Power 64-K ROM", pages 96-99<br><br>   \* Page 97, column 2, lines 6-15; page 99, paragraph "Dif-ferential Sensing Scheme"; figures 2 and 5 \*<br><br>   -- | 1,2,4, 5,7, 9 |
| | US - A - 4 004 284 (TELETYPE)<br><br>   \* Column 3, line 67 - column 4, line 39; column 8, line 23 - column 9, line 8; figures 1 and 3-6 \*<br><br>   -- | 1-3 |
| | US - A - 4 031 524 (TELETYPE)<br><br>   \* Paragraph "Sense Amplifier", columns 5-6; figures 1,2 \*<br><br>   -- | 1,2,4 |
| | US - A - 3 906 461 (SPERRY)<br><br>   \* Column 6, line 20 - column 7, line 15; figure 3 \*<br><br>   -- | 1,2,4, 5,7,9 |
| | US - A - 4 025 908 (IBM)<br><br>   \* Column 4, line 65 - column 5, line 26; figure 3C \*<br><br>   -- | 1,2,4, 5,7,9 |
| A | IBM TECHNICAL DISCLOSURE BULLETIN, vol. 21, no. 6, November 1978 Armonk, US<br><br>   ./. | 1 |

**CLASSIFICATION OF THE APPLICATION (Int. Cl.³)**

G 11 C  7/00
           17/00
H 03 K  3/356
           5/02

**TECHNICAL FIELDS SEARCHED (Int.Cl.³)**

G 11 C  7/00
           17/00
           11/24
           11/40
H 03 K  3/356
G 11 C  11/34

**CATEGORY OF CITED DOCUMENTS**

X: particularly relevant
A: technological background
O: non-written disclosure
P: intermediate document
T: theory or principle underlying the invention
E: conflicting application
D: document cited in the application
L: citation for other reasons

&: member of the same patent family, corresponding document

The present search report has been drawn up for all claims

| Place of search | Date of completion of the search | Examiner |
|---|---|---|
| The Hague | 10-09-1980 | SCHMIDT |

European Patent
Office

EUROPEAN SEARCH REPORT

0019987
Application number

EP 80 30 0162

-2-

| | DOCUMENTS CONSIDERED TO BE RELEVANT | | CLASSIFICATION OF THE APPLICATION (Int. Cl. 3) |
|---|---|---|---|
| Category | Citation of document with indication, where appropriate, of relevant passages | Relevant to claim | |
| | LOVE: "Fet Circuit for Receiving "Weak" Input Signals", page 2590 -- | | |
| A | IBM TECHNICAL DISCLOSURE BULLETIN, vol. 19, no. 5, October 1976 Armonk US ASKIN et al.: "Double-Bit Line ROS Array", pages 1683-1685. -- | 1 | |
| A | IBM TECHNICAL DISCLOSURE BULLETIN, vol. 19, no. 1, June 1976 Armonk US BALASUBRAMANIAN et al.: "Two Device per Bit, Precharged ROS with Differential Sensing", pages 164-165. -- | 1 | TECHNICAL FIELDS SEARCHED (Int. Cl. 3) |
| A | US - A - 3 613 055 (VARADI) -- | 1 | |
| A | US - A - 3 560 765 (NATIONAL SEMICONDUCTOR) -- | 1 | |
| A | IEEE INTERNATIONAL SOLID-STATE CIRCUITS CONFERENCE, vol. 20, February 1977 New York US DODSON:"Bootstrap-Pumped Control Circuitry for an MNOS EAROM" pages 182-183. -- | 1 | |
| A | US - A - 4 094 008 (NCR). -- | 1 | |
| | ./. | | |

## DOCUMENTS CONSIDERED TO BE RELEVANT

| Category | Citation of document with indication, where appropriate, of relevant passages | Relevant to claim |
|---|---|---|
| A | US - A - 3 895 360 (WESTINGHOUSE)  * Figure 4A * | 1 |
| A | US - A - 4 082 966 (TEXAS) | 1 |
| DA | US - A - 4 123 799 (MOTOROLA) | 1 |
| A | US - A - 3 969 706 (MOSTEK)  * Figure 2 * | 1 |
| A | SEMICONDUCTOR MEMORY BOOK, INTEL, Wiley Editor 1978 New York US COE: "Designing with 16K Dynamic RAMS", pages 131-138  * Figure 3 * | 1 |

CLASSIFICATION OF THE APPLICATION (Int. Cl. 3)

TECHNICAL FIELDS SEARCHED (Int. Cl. 3)